**Europäisches Patentamt**

**European Patent Office**

**Office européen des brevets**

(11) Numéro de publication: **0 223 721 B1**

# FASCICULE DE BREVET EUROPEEN

(45) Date de publication de fascicule du brevet: **20.05.92**  (51) Int. Cl.⁵: **H01L 21/306**, H01L 21/31

(21) Numéro de dépôt: **86420252.8**

(22) Date de dépôt: **15.10.86**

(54) **Procédé de gravure par plasma d'un matériau.**

(30) Priorité: **16.10.85 FR 8515612**

(43) Date de publication de la demande:
**27.05.87 Bulletin 87/22**

(45) Mention de la délivrance du brevet:
**20.05.92 Bulletin 92/21**

(84) Etats contractants désignés:
**DE FR GB IT NL**

(56) Documents cités:
**EP-A- 0 142 269**
**EP-A- 0 146 446**
**US-A- 4 213 818**

**PATENTS ABSTRACTS OF JAPAN, vol. 8, no. 25 (E-225)[1462], 2 février 1984; & JP-A-58 186 937**

**JOURNAL OF APPLIED PHYSICS, vol. 57, no. 5, 1 mars 1985, pages 1596-1601, American Institute of Physics, Woodbury, N.Y., US; K.E. GREENBERG et al.: "Kinetic processes of NF3 etchant gas discharges"**

(73) Titulaire: **ETAT FRANCAIS représenté par le Ministre des PTT (Centre National d'Etudes des Télécommunications)**
**38-40 rue du Général Leclerc**
**F-92131 Issy-les-Moulineaux(FR)**

(72) Inventeur: **Henry, Daniel**

**F-38700 Le Sappey en Chartreuse(FR)**
Inventeur: **Boswell, Roderick**
**17 Wongoola Close**
**O'Conna 2601 Canberra(AU)**

(74) Mandataire: **de Beaumont, Michel**
**1bis, rue Champollion**
**F-38000 Grenoble(FR)**

Rank Xerox (UK) Business Services
(3.08/2.19/2.0)

## Description

La présente invention concerne le domaine des procédés de gravure de matériaux par plasma, et plus particulièrement de tels procédés appliqués à l'industrie de la fabrication des composants semiconducteurs discrets et/ou intégrés.

L'invention s'applique notamment aux composants semiconducteurs à base de silicium. En effet, dans les techniques de fabrication des circuits intégrés et autres composants semiconducteurs, on utilise actuellement couramment les techniques d'attaque (ou gravure) par plasma pour enlever des parties localisées ou non de couches déposées sur des substrats.

Un exemple d'appareil de gravure par plasma apparaît dans la demande de brevet français N° 83/18300 du 17 novembre 1983 et, dans les exemples détaillés de la présente invention qui seront donnés ci-aprés, c'est un appareil de ce type qui a été utilisé pour effecteur les expérimentations.

De façon générale, dans les techniques de gravure par plasma, on cherche à améliorer diverses caractéristiques de fabrication notamment les formes de gravure (isotropes, anisotropes ou intermédiaires), les rapidités de gravure, la sélectivité de la gravure d'un type de matériau par rapport à un autre, etc....

C'est l'objet de la présente invention que de prévoir un nouveau procédé de gravure par plasma permettant d'améliorer les caractéristiques opérationnelles des procédés et des dispositifs de l'art antérieur.

Pour atteindre ces objets, la présente invention prévoit un procédé de gravure d'un matériau tel que du silicium, de la silice ou d'autres composés du silicium par un plasma dans lequel sont créés des ions actifs, consistant à interrompre périodiquement le champ électromagnétique pendant une durée inférieure ou égale au temps de relaxation desdits atomes actifs.

Sous un autre aspect, la présente invention prévoit un procédé de gravure d'un matériau par un plasma fluoré dans lequel sont créés des atomes actifs de fluor, consistant à interrompre périodiquement le champ électromagnétique pendant une durée inférieure ou égale au temps de relaxation des atomes actifs de fluor.

Dans un mode de réalisation, le rapport cyclique des interruptions est modifié au cours du traitement.

Dans un mode de réalisation, la périodicité desdites interruptions est modifiée au cours du traitement.

Dans un mode de réalisation, le matériau sur lequel agit le plasma est choisi dans le groupe comprenant Si, $SiO_2$, W, $WSi_2$.

Un dispositif pour la mise en oeuvre du procédé est constitué d'une enceinte à plasma du type classiquement utilisé dans le traitement des matériaux semiconducteurs, et comprend en outre des moyens pour interrompre périodiquement le champ haute fréquence de création du plasma.

L'enceinte à plasma peut notament être du type revendiqué dans la demande de brevet français 83/18300.

Grâce à ce procédé, la présente invention permet notamment d'obtenir une sélectivité très élevée et réglable de la gravure du silicium par rapport à la silice car, dans des conditions qui seront exposées plus en détail ci aprés, la vitesse de gravure du silicium augmente alors que la vitesse de gravure de la silice diminue, par rapport au cas où la présente invention n'est pas utilisée.

De même, la présente invention permet de faire varier par modification de paramètres électriques le caractère anisotrope d'une gravure. Ceci constitue une simplification notable par rapport aux procédés de l'art antérieur, dans lesquels cette modification d'anisotropie ne pouvait être obtenue que par variation du milieu chimique constituant le plasma ou de la pression dans l'enceinte.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1A à 1C représentent des vues en coupe d'un dispositif semiconducteur au cours d'étapes intermédiaires de fabrication ;

la figure 2 représente une tension en créneau et est destinée à exposer les notations utilisées dans la description ci-après ;

la figure 3 représente en échelle logarithmique la vitesse d'attaque en fonction de la durée d'impulsion pour le silicium et l'oxyde de silicium ($SiO_2$) ; et

la figure 4 illustre la sélectivité silicium/$SiO_2$ en fonction des mêmes paramètres qu'en figure 3.

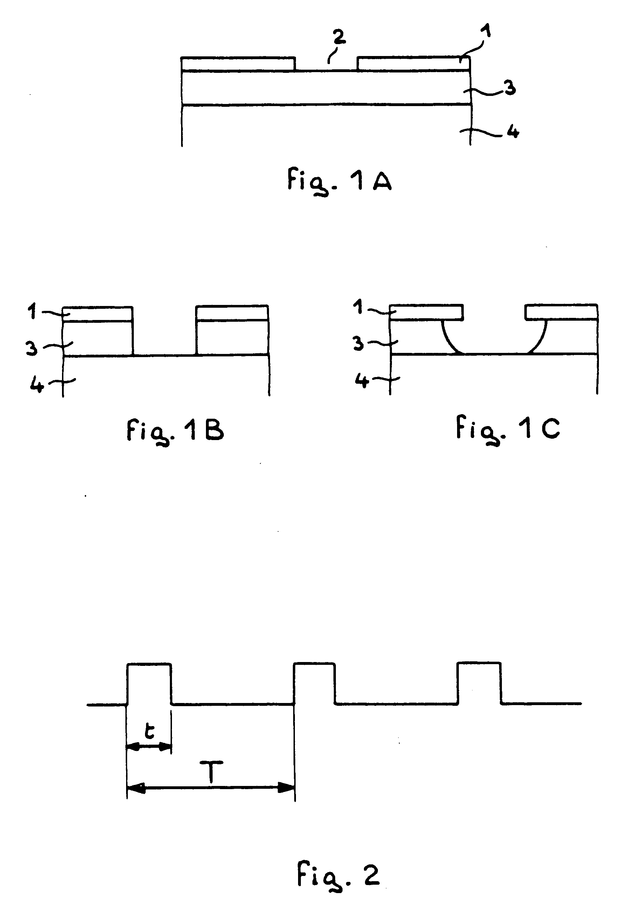

Les figures 1A, 1B et 1C représentent une configuration qui se présente souvent lors d'étapes intermédiaires de fabrication d'un composant semiconducteur. Une couche supérieure 1 comprend une ouverture 2 et repose sur une couche 3 elle-même disposée sur une autre couche ou substrat 4. En se servant de la couche 1 comme masque, on cherche à faire une ouverture correspondante totale ou partielle dans la couche 3. Dans des exemples de réalisation fréquents, la couche 1 est une couche de silice ($SiO_2$) mais ce peut aussi être une couche d'aluminium, une couche de résine ou autre produit photosensible, etc., ou une couche composite. Dans le cas d'un produit photosensible, l'ouverture 2 aura été formée directement dans la couche 1; dans le cas d'un produit non photosensible, l'ouverture 2 résulte d'une ouverture antérieurement formée dans une couche photosensible formée auparavant sur la couche 1. Cette couche photosensible pourra avoir été laissée en place ou non pour des opérations ultérieures. La couche 3 est, pour de nombreuses applications, une couche de silicium monocristallin, mais il peut s'agir de tout autre matériau, par exemple de l'un de ceux énoncés précédemment. La couche ou substrat 4 peut être un substrat de silicium, un substrat d'un matériau isolant sur lequel la couche de silicium aura été formée, ou tout autre matériau tel que décrit précédemment. Dans une application fréquente il s'agira de silicium d'un type de conductivité distinct de celui de la couche 3.

On envisage ici le cas où l'on veut réaliser l'ouverture dans la couche 3 par une attaque au plasma. Comme cela est connu, en fonction des conditions du plasma, on peut obtenir une attaque anisotrope telle que représentée en figure 1B, c'est-à-dire que les parois de la rainure formée dans la couche 3 sont verticales, ou une attaque isotrope telle que représentée en figure 1C, c'est-à-dire que les bords de l'ouverture formée dans la couche 3 sont inclinés et souvent courbes. Bien entendu, toute situation intermédiaire entre celle de la figure 1B et celle de la figure 1C peut se produire c'est-à-dire que les bords de l'ouverture seront plus ou moins inclinés. On parlera souvent en pratique de la pente de l'ouverture.

On a décrit le cas où l'on souhaitait former une ouverture dans une couche. La situation se présente de façon symétrique dans le cas où l'on souhaite au contraire laisser en place un îlot d'une couche.

De façon habituelle, un plasma est produit dans une enceinte à très faible pression par un champ magnétique à haute fréquence appliqué de façon continue. Selon la présente invention, comme le représente la figure 2, le champ magnétique est modulé par un signal en créneau de sorte qu'il n'est appliqué que pendant des intervalles de temps t répétitifs selon une période T. De façon classique, on appellera rapport cyclique le rapport t/T entre la durée d'application du champ haute fréquence et la durée d'interruption de ce champ.

En réalisant une telle modification de l'application du champ électromagnétique les conditions d'attaque par un plasma dans une enceinte classique de formation de plasma sont modifiées et, qui plus est, sont modifiées de façon distincte pour des produits à attaquer différents.

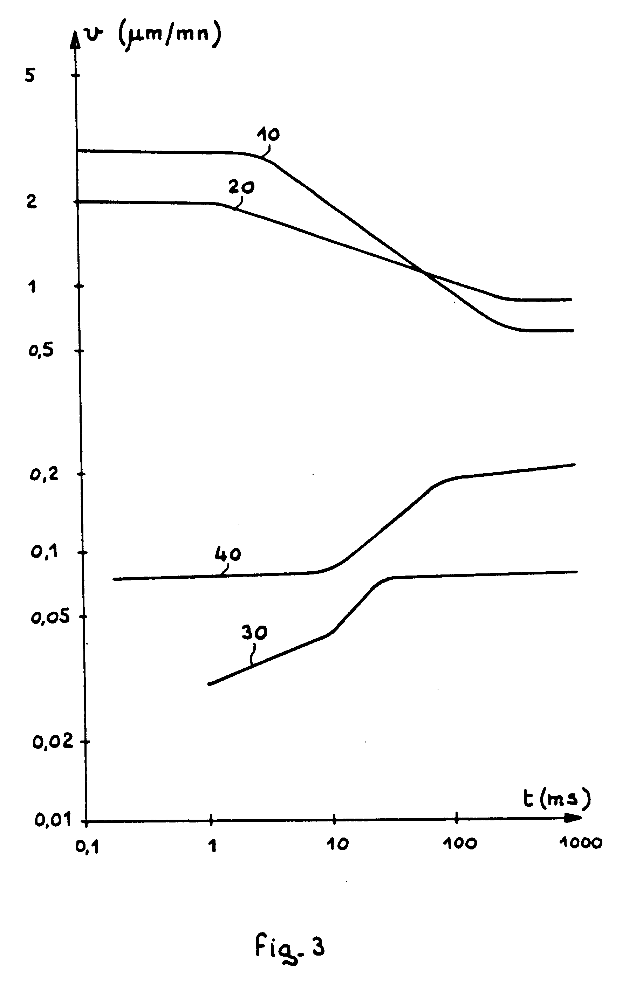

A titre d'exemple, la figure 3 représente sur une courbe à échelle logarithmique la vitesse d'attaque (v) du silicium et de la silice en micromètres par minute dans le cas d'impulsions présentant un rapport cyclique constant de 20 % quand la durée des impulsions (t) varie de 0,1 à 1000 ms. Dans l'exemple représenté, un appareil tel que décrit dans la demande de brevet français N° 83/18300 susmentionnée à été utilisé avec un plasma de $SF_6$, un débit de gaz de $2 cm^3/mn$, une pression de 0,9 Pa (7 mtorr), un champ magnétique de $5 \times 10^{-3}$ T (50 gauss), une fréquence haute de 7 MHz, une puissance haute fréquence de 700 W, dans les cas où l'échantillon refroidi est placé sur un substrat flottant ou polarisé à -100V. En figure 3, les courbes 10 et 20 correspondent à l'attaque du silicium dans le cas d'un substrat flottant et d'un substrat polarisé à -100 V, respectivement, et les courbes 30 et 40 sont des courbes correspondantes pour $SiO_2$.

On notera tout d'abord que, pour du silicium, la vitesse d'attaque est sensiblement la même dans le cas où le champ haute fréquence est haché selon l'invention que dans le cas d'un champ continu dès que t est inférieur à quelques millisecondes. Ainsi, avec une consommation cinq fois plus faible en énergie, on obtient la même vitesse d'attaque. Ceci présente un avantage notable. En effet, la réduction de consommation d'énergie entraîne que les substrats sont moins chauffés et donc que les dispositifs de refroidissement de substrats, qui constituent généralement une contrainte dans les enceintes à plasma, peuvent être simplifiés.

On voit aussi que, pour du silicium, la vitesse de gravure à rapport cyclique donné en fonction de la durée de l'impulsion présente deux états stationnaires : grande vitesse de gravure pour des impulsion brèves (moins de 5 ms), vitesse cinq fois plus faible pour des impulsions longues (plus de 500 ms), ces états étant séparés par une décroissance exponentielle. Par contre, le comportement de la silice est symétrique de celui du silicium : vitesse de gravure constante et faible pour des impulsions brèves, vitesse de gravure constante et plus rapide pour des impulsions longues, avec une croissance exponentielle entre ces deux régimes.

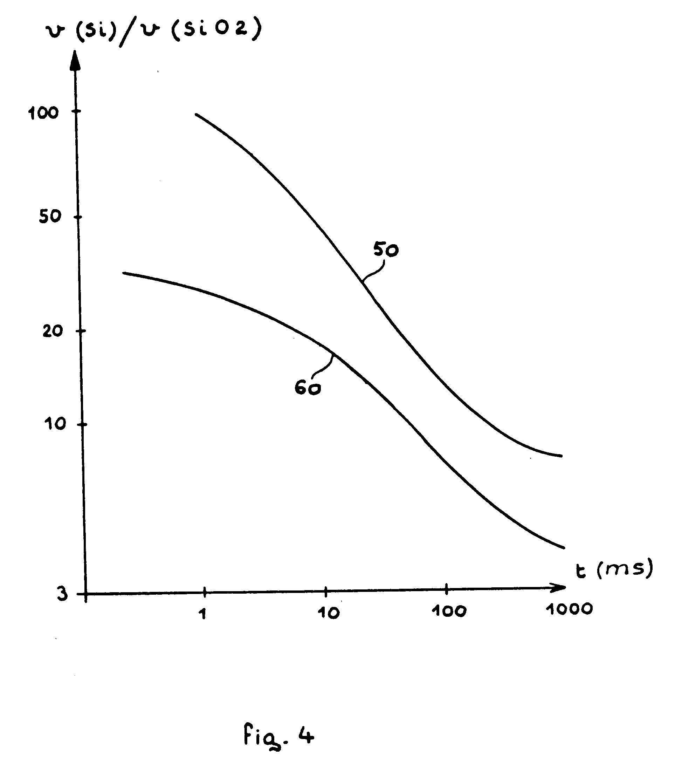

Ainsi, la figure 3 met en évidence le fait que, pour le silicum, à partir du moment où la durée des impulsions est de l'ordre de quelques ms, ou moins, l'intervalle entre impulsions étant quatre fois plus grand, la vitesse d'attaque est sensiblement la même que dans le cas de l'application d'un champ continu alors qu'au contraire pour la silice, le fait de hacher le champ générateur de plasma réduit la vitesse d'attaque d'un facteur supérieur à 10. On augmente ainsi, comme le représente la figure 4, la sélectivité d'attaque du silicium par rapport à la silice. En figure 4, la courbe 50 correspond au cas d'un substrat flottant (rapport entre les courbes 10 et 30) et la courbe 60 correspond au cas d'un substrat polarisé à -100 V (rapport entre les courbes 20 et 40). Ceci constitue un avantage important. En effet, dans le cas de l'exemple des figures 1 illustrées ci-dessus, la couche isolante 1 est très souvent de la silice alors que la couche à attaquer 3 est très souvent du silicium. Le fait que la sélectivité d'attaque du silicium par rapport à la silice augmente, entraîne que l'on pourra protéger une couche de silicium dans laquelle on veut faire une ouverture par une couche de silice beaucoup plus mince, d'où il résulte une simplification des procédures et une réduction de leurs durées.

Bien que l'explication des raisons du fonctionnement du procédé de hachage selon la présente invention ne soit pas certaine à ce jour, on estime que le paramètre à prendre en compte pour déterminer la durée d'interruption entre impulsions ou le rapport cyclique, est le temps de relaxation des atomes neutres actifs du plasma. Pour des atomes de fluor dans le cas d'un plasma à base de $SF_6$, cette durée est de l'ordre de quelques dizaines de ms, ce qui correspond bien à la zone de stabilisation des courbes représentées en figure 3. On estime ainsi, que dans le cas d'une attaque du silicium, pendant les interruptions du champ créateur du plasma, des atomes actifs de fluor restent en place et continuent à attaquer la couche de silicium.

Selon un aspect de la présente invention, l'attaque du silicium en l'absence du champ créateur de plasma est isotrope. Ainsi, à fréquence élevée, pour un rapport cyclique faible, par exemple de 20 % comme indiqué précédemment, l'attaque est essentiellement isotrope et l'on trouve une allure du type représenté en figure 1C, c'est-à-dire que les bords latéraux de la couche attaquée sont inclinés et présentent une faible pente. Par contre, quand le rapport cyclique augmente, on se rapproche du cas anisotrope tel que représenté en figure 1B, c'est-à-dire que la pente des bords latéraux de la couche attaquée est très forte.

Pour pouvoir expliquer les résultats obtenus, il faut considérer deux régimes de gravure :
- la gravure liée à la présence du plasma,
- la gravure liée à la post décharge.

En présence de plasma, la gravure est due à l'action des particules neutres réactives et du bombardement ionique ; ce régime de fonctionnement permet d'obtenir une gravure anisotrope si le substrat est polarisé ; la sélectivité est faible. En régime de post décharge, la gravure est due uniquement à l'action des atomes réactifs, ce régime fournit une gravure isotrope et très sélective.

En jouant sur le rapport cyclique ou la fréquence de modulation on privilégie l'un ou l'autre des régimes, ce qui permet de passer continuellement d'un régime isotrope et sélectif à un régime anisotrope et peu sélectif.

Un avantage de la présente invention est donc qu'en faisant varier le rapport cyclique à fréquence donnée en cours de processus, on peut "sculpter" les bords d'attaque de façon souhaitée pour obtenir par exemple une partie supérieure évasée suivie d'une partie profonde raide, ce qui peut être intéressant dans le cas où l'on veut réaliser des rainures relativement profondes tout en facilitant le recouvrement par des couches ultérieures sans provoquer de rupture de couches au niveau des bords de rainures.

Cette possibilité selon la présente invention de modifier la sélectivité d'une attaque et le caractère isotrope ou anisotrope de cette attaque uniquement par action sur un paramètre électrique simplifie beaucoup le traitement par rapport au cas de l'art antérieur où modifications pouvaient seulement être éventuellement obtenues en modifiant le débit des constituants gazeux du plasma, ce qui était malcommode, peu fiable et entraînait un temps de réponse assez lent.

Ainsi, la présente invention, décrite seulement dans le cas d'un mode de réalisation particulier, ouvre une nouvelle voie pour l'utilisation des enceintes à plasma quels que soient les gaz d'attaque constituant le plasma et les matériaux attaqués.

D'autre part, tout appareil de formation de plasma peut facilement être modifié pour mettre en oeuvre la présente invention en effectuant selon le cas le hachage par action directe sur le générateur haute fréquence, par action sur la transmission du signal entre ce générateur et l'emplacement où se développe le plasma, ou encore par action sur un paramètre accessoire permettant d'interrompre la formation du plasma.

**Revendications**

1. Procédé de gravure d'un matériau par un plasma dans lequel sont créés des ions et des atomes actifs, caractérisé en ce qu'il consiste à interrompre périodiquement le champ électromagnétique pendant une durée inférieure au temps de relaxation desdits atomes actifs.

2. Procédé de gravure selon la revendication 1, caractérisé en ce que le matériau est compris dans le groupe comprenant le silicium, la silice et d'autres composés de silicium, le tungstène et le siliciure de tungstène.

3. Procédé de gravure selon la revendication 1 ou 2 caractérisé en ce que la plasma est un plasma fluoré dans lequel sont créés des atomes actifs de fluor.

4. Procédé selon l'une quelconque des revendications 1 à 3, caractérisé en ce que le rapport cyclique des interruptions est modifié au cours du traitement.

**5.** Procédé selon l'une quelconque des revendications 1 à 3, caractérisé en ce que la périodicité desdites interruptions est modifiée au cours du traitement.

**Claims**

**1.** A method for etching a material by a plasma in which are created active ions and atoms, characterized in that it comprises the step of periodically interrupting the electromagnetic field during a time duration lower than the relaxation time of said active atoms.

**2.** An etching method according to claim 1, characterized in that said material is comprised in the group comprising silicon, silicon oxide and other silicon compounds, tungsten and tungsten silicide.

**3.** An etching method according to claim 1 or 2, characterized in that said plasma is a fluorined plasma in which are created active fluorine atoms.

**4.** A method according to any of claims 1 to 3, characterized in that the duty cycle of the interruptions is modified during the process.

**5.** A method according to any of claims 1 to 3, characterized in that the periodicity of said interruptions is modified during the process.

**Patentansprüche**

**1.** Verfahren zum Ätzen eines Materials mit einem Plasma, in dem aktive Ionen und Atome erzeugt werden, dadurch gekennzeichnet, daß das elektromagnetische Feld periodisch während einer Dauer unterbrochen wird, die kürzer als die Relaxationszeit der aktiven Atome ist.

**2.** Ätzverfahren nach Anspruch 1, dadurch gekennzeichnet, daß das Material in der Gruppe vorhanden ist, in der Silizium, Siliziumoxid und andere Siliziumverbindungen, Wolfram und Wolframsilizid vorhanden sind.

**3.** Ätzverfahren nach Anspruch 1 oder 2, dadurch gekennzeichnet, daß das Plasma ein fluoriertes Plasma ist, in dem aktive Fluoratome erzeugt werden.

**4.** Verfahren nach einem der Ansprüche 1 bis 3, dadurch gekennzeichnet, daß der periodische Arbeitszyklus der Unterbrechungen im Laufe des Verfahrens modifiziert wird.

**5.** Verfahren nach einem der Ansprüche 1 bis 3, dadurch gekennzeichnet, daß die Periodizität der Unterbrechungen im Laufe des Verfahrens modifiziert wird.

Fig. 1 A

Fig. 1 B

Fig. 1 C

Fig. 2

Fig. 3

Fig. 4